# EUROPEAN PATENT APPLICATION

(11) **EP 3 404 839 A1**
(43) Date of publication of application: **21.11.2018**
(21) Application number: 18172048.3
(22) Date of filing: 14.05.2018
(51) Int. Cl.: H03M 7/30

(54) **ENCODING PROGRAM, ENCODING DEVICE, AND ENCODING METHOD**

(30) Priority: 16.05.2017 JP 2017097667
(71) Applicant: FUJITSU LIMITED, Kanagawa 211-8588 (JP)
(72) Inventor: KATAOKA, Masahiro, Kanagawa, 211-8588 (JP); NAKATSU, Toshihide, Kanagawa, 211-8588 (JP); TANAKA, Hideaki, Kanagawa, 211-8588 (JP)
(74) Representative: Hoffmann Eitle

(57) **Abstract**

An information processing device (100) executes a process including reading data to be encoded from target text data, encoding a numerical value notation character string representing a numerical value included in the data to be encoded, and registering numerical value data corresponding to the numerical value notation character string and a code in a dictionary in an associated manner based on the encoding.

## Description

### FIELD

The embodiments discussed herein are related to an encoding program, an encoding device, and an encoding method.

### BACKGROUND

Techniques for extracting a numerical value from a text file to be compressed, and encoding the extracted numerical value in number units has been known. In such techniques, dynamic codes are assigned to numbers from 0 to 9, and the numbers included in the numerical value extracted from the text file to be compressed are converted to dynamic codes. Moreover, a numerical value is converted to dynamic codes by adding a code representing information relating to the numerical value such as specification of full-size characters or half-size characters, the presence of a comma, the presence of a decimal point, the number of significant digits, and the like, to the converted dynamic codes.
Patent Document 1: International Publication Pamphlet No. WO2008/047432
Patent Document 2: Japanese Laid-open Patent Publication No. 2013-150041
Patent Document 3: Japanese Laid-open Patent Publication No. 05-174064

Accordingly, it is an object in one aspect of an embodiment of the invention to provide an encoding program, an encoding device, and an encoding method that can accelerate the calculation speed of an encoded numerical value.

### SUMMARY

According to an aspect of the embodiments, a n encoding program that causes a computer to execute a process. The process includes reading (111) data to be encoded from target text data; encoding (112) a numerical value notation character string representing a numerical value included in the data to be encoded; and registering (112) numerical value data corresponding to the numerical value notation character string and a code in a dictionary in an associated manner based on the encoding.

### BRIEF DESCRIPTION OF DRAWINGS

FIG. 1 is a diagram for explaining an encoding process of a numerical value in a first embodiment;
FIG. 2 is a diagram for explaining an example of a system configuration of an information processing device;
FIG. 3 is a diagram illustrating an example of a system configuration according to the encoding process in the first embodiment;
FIG. 4 is a diagram illustrating a first example of a bit filter;
FIG. 5 is a diagram illustrating an example of a dynamic dictionary;
FIG. 6 is a diagram illustrating a second example of the bit filter;
FIG. 7 is a diagram illustrating an example of a flow of the encoding process in the first embodiment;
FIG. 8 is a diagram for explaining a state in which CSV data in a second embodiment is encoded;
FIG. 9A is a diagram 1 for explaining arithmetic processing of a numerical value in the second embodiment;
FIG. 9B is a diagram 2 for explaining arithmetic processing of a numerical value in the second embodiment;
FIG. 9C is a diagram 3 for explaining arithmetic processing of a numerical value in the second embodiment;
FIG. 10 is a diagram illustrating a hardware configuration of the information processing device in the first and second embodiments;
FIG. 11 is a diagram illustrating a structural example of a computer program operated in a computer; and
FIG. 12 is a diagram illustrating a structural example of devices in a system in the embodiments.

### DESCRIPTION OF EMBODIMENTS

However, in the above-described techniques, when the numerical value is encoded in number units, the numerical value before being encoded will be lost. Consequently, it is not possible to perform calculation on the basis of the numerical value until the numerical value is decoded. Hence, when a numerical value is encoded in number units, it may take some time to calculate the encoded numerical value.

Preferred embodiments will be explained with reference to accompanying drawings. It is to be understood that the scope of the invention is not limited to the embodiments. The embodiments may be suitably combined within a range that does not contradict the processing contents.

### [a] First Embodiment

### Encoding Process in First Embodiment

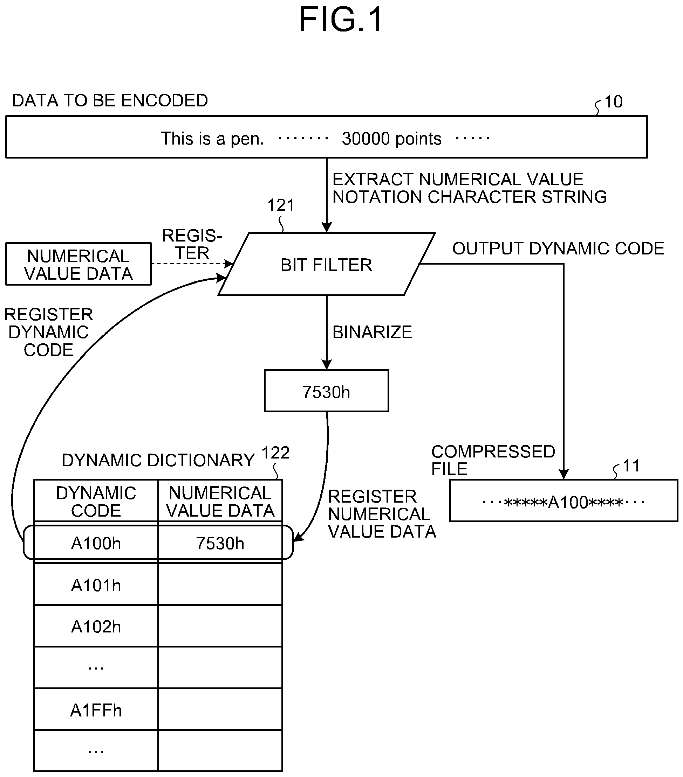

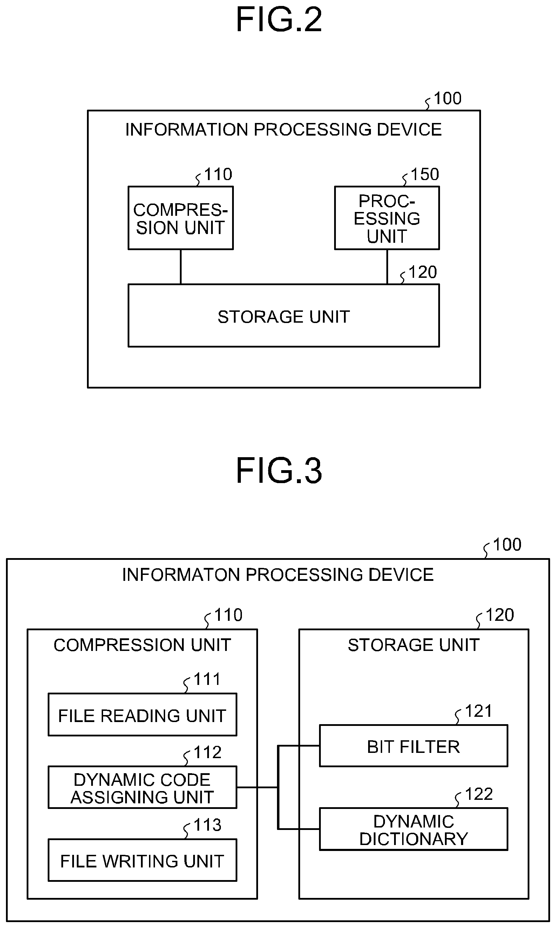

An encoding process performed by an information processing device 100 (see FIG. 2) in a first embodiment will be described with reference to FIG. 1. FIG. 1 is a diagram for explaining an encoding process of a numerical value in the first embodiment. As illustrated in the example of FIG. 1, the information processing device 100 separates "This is a pen.... 30000 points ..." that is included in data to be encoded 10 and that is a target of the encoding process, into numerical values or words such as "This" "is" "a" "pen" "30000" and "points", and obtains the numerical values or the words. Hereinafter, a numerical value including the number of one or more is referred to as a "numerical value notation character string".

The thus-obtained numerical value notation character string may include a code such as a plus code, a minus code, a comma, and a decimal point in addition to numbers. The information processing device 100 extracts the numerical value notation character string "30000" among the obtained words, and outputs the obtained numerical value notation character string "30000" to a bit filter 121. The bit filter 121 is a dictionary that maps numerical value data to a dynamic code relative to the numerical value notation character string. Numerical value data corresponding to the numerical value notation character strings are registered in the bit filter 121 in advance. For example, numerical value data "0000h", "0001h", "0002h", "0003h", "0004h" ... corresponding to integers "0", "1", "2", "3", "4" ... are sequentially registered in the bit filter 121 in advance. Details of the data structure of the bit filter 121 will be described below.

Next, the information processing device 100 obtains numerical value data "7530h" corresponding to the numerical value notation character string "30000" from the bit filter 121. The numerical value data is data obtained by binarizing the corresponding numerical value notation character string. Next, the information processing device 100 registers the obtained numerical value data "7530h" and the dynamic code "A100h" that is dynamically assigned to the numerical value data in the order that the numerical value data are registered in a dynamic dictionary 122, in the dynamic dictionary 122 in an associated manner. It is to be noted that "h" at the end of the numerical value data "7530h", the dynamic code "A100h", and the like is a code indicating that the value is represented in hexadecimal.

Next, the information processing device 100 associates the dynamic code "A100h" dynamically assigned in the dynamic dictionary 122 with the numerical value notation character string "30000", and registers the dynamic code "A100h" in the bit filter 121. The information processing device 100 then obtains the dynamic code "A100h" corresponding to the numerical value notation character string "30000" on the basis of the bit filter 121, and outputs the dynamic code "A100h" to a compressed file 11.

Moreover, when the numerical value notation character string "30000" appears in the data to be encoded 10 next time, the information processing device 100 obtains the dynamic code "A100h" that is already registered in the bit filter 121, and outputs the dynamic code "A100h" to the compressed file 11.

### Comparison between First Embodiment and Reference Example

As described above, in the first embodiment, the entire numerical value notation character string is encoded as a single unit (single dynamic code). On the other hand, in a reference example, an individual number in the numerical value notation character string is encoded as a single unit. When the numerical value notation character string is encoded in number units as in the reference example, the numerical value represented by the numerical value notation character string will be lost. Thus, when the numerical value such as this is used for calculation, the numerical value needs to be decoded before calculation. Alternatively, as in the first embodiment, when the numerical value data obtained by binarizing the numerical value notation character string and the dynamic code are encoded in the dynamic dictionary 122 in an associated manner, it is possible to perform calculation directly by referring to the dynamic dictionary 122. Consequently, compared to the reference example, it is possible to reduce the decoding load during calculation, and accelerate the calculation speed.

### Configuration of Processing Unit relating to Encoding Process in First Embodiment

A relation between a compression unit 110 and a storage unit 120 of the information processing device 100 will be described with reference to FIG. 2. FIG. 2 is a diagram for explaining an example of a system configuration of the information processing device 100. As illustrated in the example of FIG. 2, the storage unit 120 of the information processing device 100 is connected to the compression unit 110 and a processing unit 150. For example, the storage unit 120 corresponds to a semiconductor memory device such as a random access memory (RAM), a read only memory (ROM), and a flash memory, and a storage device such as a hard disk and an optical disc.

The information processing device 100 also includes the compression unit 110 and the processing unit 150. The functions of the compression unit 110 and the processing unit 150 can be implemented when a central processing unit (CPU) executes a predetermined computer program. The functions of the compression unit 110 and the processing unit 150 can also be implemented by an integrated circuit such as an application specific integrated circuit (ASIC) and a field programmable gate array (FPGA), for example.

The compression unit 110 extract a numerical value notation character string including at least one number indicating a numerical value, from the input data. The compression unit 110 refers to a dictionary in which a numerical value notation character string and a dynamic code are stored in an associated manner, and converts the numerical value notation character string to the dynamic code corresponding to the extracted numerical value notation character string.

The dictionary includes a first dictionary that stores therein a predetermined plurality of numerical value notation character strings in advance and a second dictionary that stores therein the numerical value notation character string registered in the first dictionary. When the extracted numerical value notation character string is registered in the first dictionary but the dynamic code corresponding to the numerical value notation character string is not registered in the first dictionary, the compression unit 110 assigns a dynamic code to the numerical value notation character string, and registers the dynamic code associated with the numerical value notation character string in the first dictionary. For example, the first dictionary is a bit filer. For example, the second dictionary is a dynamic dictionary.

The first dictionary is a dictionary in which the numerical value notation character strings that may be extracted and codes that are assigned to the numerical value according to the size of the numerical value are further stored in an associated manner.

A system configuration according to the encoding process of the first embodiment will be described with reference to FIG. 3. FIG. 3 is a diagram illustrating an example of a system configuration according to the encoding process in the first embodiment. As illustrated in the example of FIG. 3, the information processing device 100 includes the compression unit 110 and the storage unit 120. The compression unit 110 includes a file reading unit 111, a dynamic code assigning unit 112, and a file writing unit 113. The storage unit 120 includes the bit filter 121 and the dynamic dictionary 122. Hereinafter, configurations of the compression unit 110 and the storage unit 120 of the first embodiment will be described in detail. It is to be noted that the file reading unit 111 is an example of a reading unit, and the dynamic code assigning unit 112 is an example of an encoding execution unit and a registration unit.

### Configuration of Storage Unit

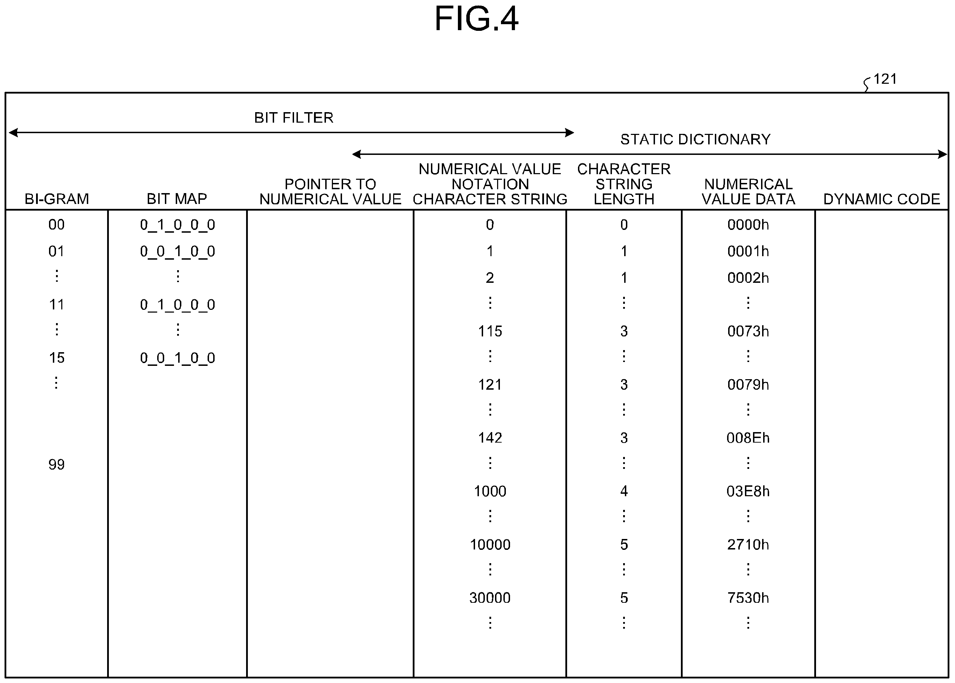

First, the bit filter 121 will be described. The bit filter 121 is a dictionary in which numerical value data and a dynamic code are associated with a numerical value notation character string. FIG. 4 is a diagram illustrating a first example of the bit filter 121. As illustrated in the example of FIG. 4, a bi-gram, a bit map, a numerical value notation character string, character string length, numerical value data, and a dynamic code are associated with each other in the bit filter 121. The "bi-gram" is continuous numbers included in each word. For example, "115" includes bi-grams corresponding to "11" and "15".

The "bit map" represents a bit map corresponding to the character string of the bi-gram. For example, "115" is associated with the bit map "0_1_0_0_0" of the bi-gram "11" and the bit map "0_1_0_0_0" of the bi-gram "15" by a pointer to the numerical value notation character string. For example, when "115" is obtained from the data to be encoded 10, the information processing device 100 accesses the numerical value notation character string "115" by using the bit map "0_1_0_0_0" of the bi-gram "11" and the bit map "0_1_0_0_0" of the bi-gram "15".

The "numerical value notation character string" is a numerical value notation character string registered in the bit filter 121. For example, the "numerical value notation character strings" are registered with serial numbers such as "0", "1", "2" ... "100", "101" ... "999", "1000" .... The "numerical value notation character string" may also include a numerical value notation character string including a comma "," at every three digits. The "numerical value notation character string" may also include a negative value and a value of a decimal point or less. The "character string length" is the number of digits of the numerical value notation character string.

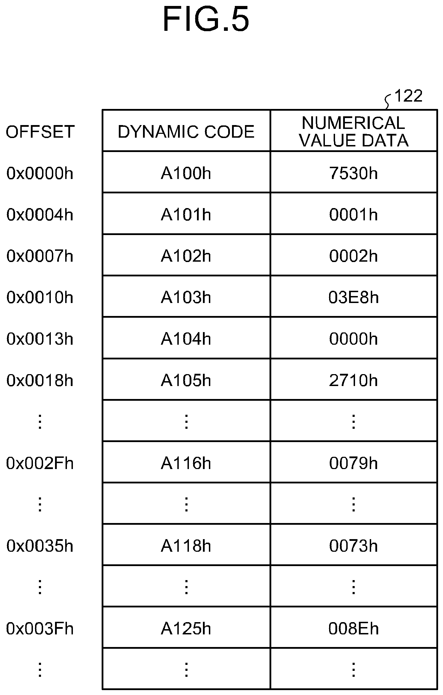

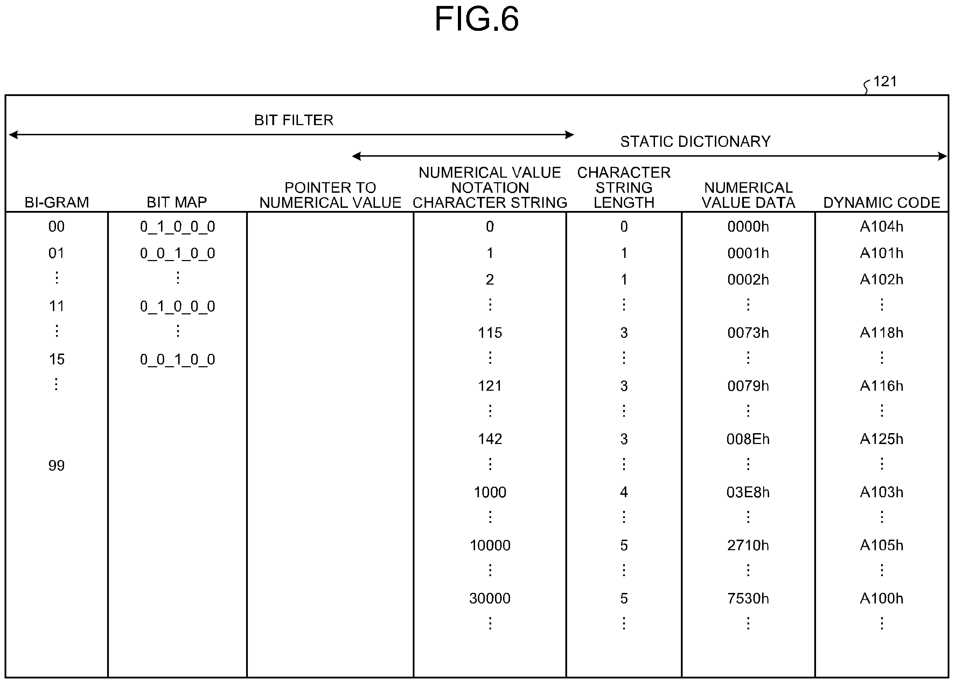

The "numerical value data" is data that is assigned to the numerical value notation character string and that is obtained by binarizing the numerical value represented by the corresponding numerical value notation character string. For example, in the "numerical value data", the binarized numerical value data "0000h", "0001h", "0002h", "0003h" ... are respectively assigned to the numerical value notation character strings "0", "1", "2", "3", "4" ... enumerated in an ascending order. In the example of FIG. 4, the data in the items are stored as records in an associated manner. However, as long as it is possible to keep the relation between the items associated with each other in the above description, the data may be stored in other ways. The same applies for the bit filter 121 and the dynamic dictionary 122 illustrated in FIG. 5 and FIG. 6, which will be described below.

Next, the dynamic dictionary 122 will be described. The dynamic dictionary 122 is a dictionary that maps the numerical value data and the dynamic code assigned to the numerical value data. FIG. 5 is a diagram illustrating an example of the dynamic dictionary 122. As illustrated in the example of FIG. 5, the dynamic code and the numerical value data are associated with each other in the dynamic dictionary 122. The "numerical value data" is numerical value data obtained by the bit filter 121. For example, the "dynamic code" is a dynamic code having a fixed length assigned to the numerical value data in an ascending order, in the order that the numerical value data are registered in the dynamic dictionary 122.

For example, when the information processing device 100 extracts the numerical value notation character strings from the data to be encoded 10 in the order of "3000", "1", "2", "1000", ..., the dynamic codes "A100h", "A101h", "A102h", "A103h" are respectively assigned to the numerical value data "7530h", "0001h", "0002h", "03E8h", ..., of the numerical value notation character strings. The information processing device 100 then registers the dynamic code assigned to each of the numerical value notation character strings in the dynamic dictionary 122. For example, the information processing device 100 associates the dynamic code "A100h" and the numerical value data "7530h" of the numerical value notation character string "3000" at the position of the offset "0x0000h". Moreover, the information processing device 100 associates the dynamic code "A101h" with the numerical value data "0001h" of the numerical value notation character string "1" at the position of the offset "0x0004h". Furthermore, the information processing device 100 associates the dynamic code "A102h" with the numerical value data "0002h" of the numerical value notation character string "2" at the position of the offset "0x0007h".

### Configuration of Compression Unit

Returning to FIG. 3, the configuration of the compression unit 110 will be described. The file reading unit 111 is a processing unit that reads the data to be encoded 10 and that extracts a numerical value notation character string from the data to be encoded 10. The file reading unit 111 separates the character string into words or numerical value notation character strings by using a space character or a comma in the character string of the data to be encoded 10, and extracts the numerical value notation character string from the data to be encoded 10. The file reading unit 111 then outputs the extracted numerical value notation character string to the dynamic code assigning unit 112.

The dynamic code assigning unit 112 is a processing unit that assigns a dynamic code to the numerical value notation character string extracted from the data to be encoded 10. Upon receiving the numerical value notation character string from the file reading unit 111, the dynamic code assigning unit 112 accesses the "numerical value notation character string" registered in the bit filter 121.

When the dynamic code corresponding to the accessed "numerical value notation character string" is already registered in the bit filter 121, the dynamic code assigning unit 112 obtains the dynamic code corresponding to the numerical value notation character string from the bit filter 121 and outputs the obtained dynamic code to the file writing unit 113.

When the dynamic code corresponding to the accessed numerical value notation character string is not registered in the bit filter 121, the dynamic code assigning unit 112 obtains numerical value data corresponding to the numerical value notation character string from the bit filter 121. Next, the dynamic code assigning unit 112 registers the numerical value data obtained from the bit filter 121 and the dynamic code that is assigned to the numerical value data in the order that the numerical value data are registered in the dynamic dictionary 122, in the dynamic dictionary 122 in an associated manner.

A specific example of registering a dynamic code in the dynamic dictionary 122 will be described with reference to FIG. 5. As illustrated in the example of FIG. 5, the dynamic code assigning unit 112 associates the dynamic code "A102h with the numerical value data "0002h" of the numerical value notation character string "2" having been registered third, and registers the numerical value data "0002h" and the dynamic code "A102h" in the dynamic dictionary 122. The dynamic code assigning unit 112 also associates the dynamic code "A105h" with the numerical value data "2710h" of the numerical value notation character string "10000" having been registered sixth, and registers the numerical value data "2710h" and the dynamic code "A105h" in the dynamic dictionary 122. In this manner, the dynamic code assigning unit 112 assigns a dynamic code to the numerical value data of the numerical value notation character string corresponding to the order that the numerical value data are registered in the dynamic dictionary 122. The dynamic code assigning unit 112 then registers the numerical value data of the numerical value notation character string and the assigned dynamic code in the dynamic dictionary 122 in an associated manner.

Next, the dynamic code assigning unit 112 associates the dynamic code registered in the dynamic dictionary 122 with the numerical value data, and registers the dynamic code in the bit filter 121.

A specific example of the bit filter 121 after the registration number and the dynamic code are registered will be described with reference to FIG. 6. FIG. 6 is a diagram illustrating a second example of the bit filter 121. As illustrated in the example of FIG. 6, dynamic codes are registered in the bit filter 121. In the bit filter 121, the "dynamic code" is a dynamic code corresponding to the numerical value notation character string. For example, the dynamic code "A116h" assigned to the numerical value notation character string "121" is registered in the bit filter 121.

The dynamic code assigning unit 112 then outputs the dynamic code registered in the bit filter 121 to the file writing unit 113.

The file writing unit 113 is a processing unit that generates a compressed file 11 on the basis of the dynamic code output from the dynamic code assigning unit 112. For example, the file writing unit 113 stores the dynamic code of the numerical value notation character string output from the dynamic code assigning unit 112 in a buffer, and generates compressed data. The file writing unit 113 generates the compressed file 11 on the basis of the compressed data generated in the buffer.

### Flow of Encoding Process in First Embodiment

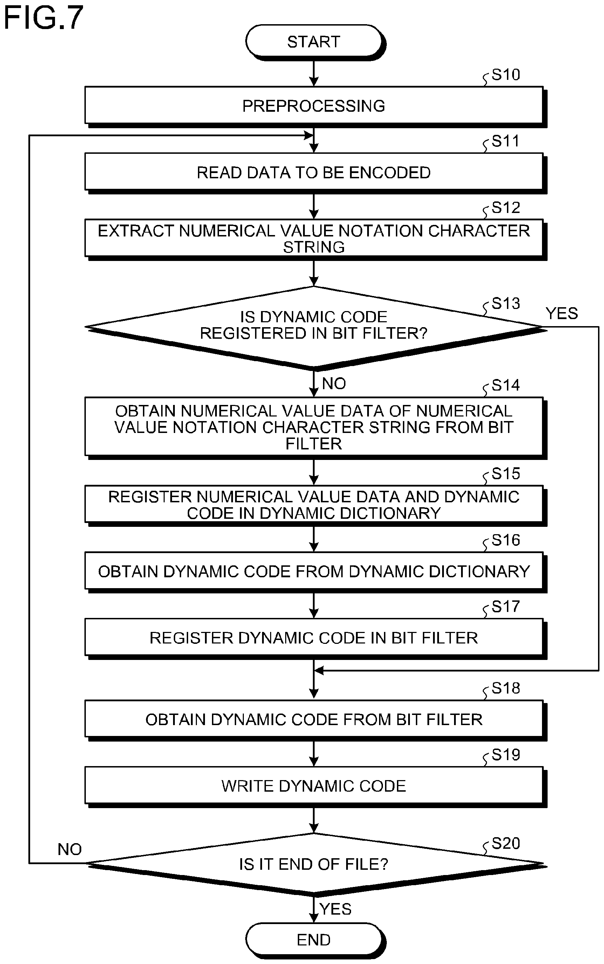

Next, a flow of the encoding process in the first embodiment will be described. FIG. 7 is a diagram illustrating an example of the flow of the encoding process in the first embodiment. As illustrated in the example of FIG. 7, the information processing device 100 first performs preprocessing (step S10). For example, the information processing device 100 obtains an area for holding the bit filter 121 and a work area for creating the dynamic dictionary 122 in the preprocessing. Next, the file reading unit 111 reads the data to be encoded 10 (step S11), and extract a numerical value notation character string from the data to be encoded 10 (step S12).

Next, the dynamic code assigning unit 112 determines whether the dynamic code corresponding to the numerical value notation character string extracted from the data to be encoded 10 is registered in the bit filter 121 (step S13). When the dynamic code is registered in the bit filter 121 (Yes at step S13), the dynamic code assigning unit 112 proceeds to a process at step S18.

Alternatively, when the dynamic code is not registered in the bit filter 121 (No at step S13), the dynamic code assigning unit 112 obtains numerical value data of the numerical value notation character string from the bit filter 121 (step S14). Next, the dynamic code assigning unit 112 registers the numerical value data obtained from the bit filter 121 and the dynamic code assigned to the numerical value data in the order that the numerical value data are registered in the dynamic dictionary 122 in the dynamic dictionary 122 in an associated manner (step S15). For example, the dynamic code assigning unit 112 assigns the dynamic codes "A100h", "A101h", "A102h", "A103h", "A104h", "A105h", ... to the numerical value data in the order that the numerical value data are registered in the dynamic dictionary 122. The dynamic code assigning unit 112 obtains the registered dynamic code from the dynamic dictionary 122 (step S16). Next, the dynamic code assigning unit 112 associates the dynamic code obtained from the dynamic dictionary 122 with the numerical value data, and registers the dynamic code in the bit filter 121 (step S17).

Next, the dynamic code assigning unit 112 obtains the dynamic code corresponding to the numerical value notation character string from the bit filter 121 (step S18). The file writing unit 113 then writes the dynamic code obtained from the bit filter 121 in the compressed file 11 (step S19) .

The file reading unit 111 determines whether the reading position of the file is the end of the file (step S20). When the reading position is the end of the file (Yes at step S20), the file reading unit 111 finishes the process. When the reading position is in the middle of the file (No at step S20), the file reading unit 111 returns to the process at step S11.

In this manner, the information processing device 100 of the first embodiment assigns a dynamic code to the numerical value notation character string included in the data to be encoded 10. Consequently, it is possible to reduce the code length to be assigned to the numerical value notation character string during the encoding process.

### Advantageous Effects

The compression unit 110 reads out the data to be encoded 10 from target text data. The compression unit 110 encodes the numerical value notation character string representing the numerical value in the data to be encoded 10, and registers the numerical value data corresponding to the numerical value notation character string and the code in the dictionary in an associated manner, depending on the encoding. Consequently, it is possible to accelerate the calculation speed of the encoded numerical value.

The numerical value data is data obtained by binarizing the numerical value represented by the numerical value notation character string. Thus, it is possible to perform calculation directly from the encoded dynamic code by referring to the dynamic dictionary 122. Consequently, it is possible to further accelerate the calculation speed of the encoded numerical value.

### [b] Second Embodiment

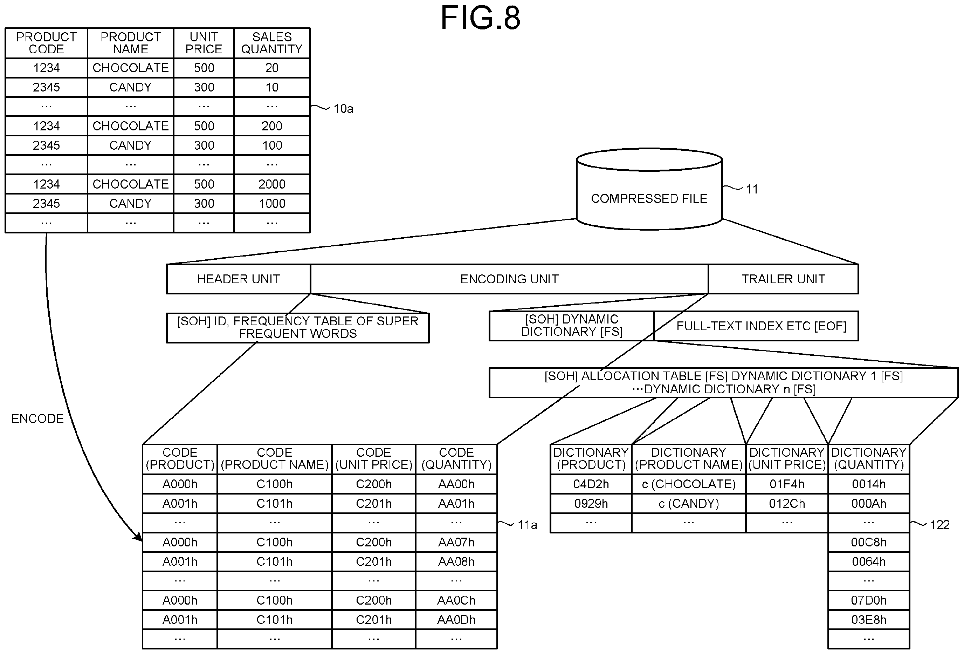

In a second embodiment, an arithmetic process of a numerical value encoded as illustrated in the first embodiment will be described. FIG. 8 is a diagram for explaining a state in which comma-separated values (CSV) data 10a in the second embodiment is encoded. As illustrated in the example of FIG. 8, the compressed file 11 includes compressed CSV data 11a in which the CSV data 10a, which is an example of the data to be encoded 10, is encoded.

As illustrated in the example of FIG. 8, the compressed file 11 includes a header unit, an encoding unit, and a trailer unit. The dynamic code (for example, the encoded compressed CSV data 11a) is stored in the encoding unit, and the dynamic dictionary 122 is stored in the trailer unit.

As illustrated in the first embodiment, the compression unit 110 registers the numerical value data indicating the numerical value notation character string and the dynamic code in the dynamic dictionary 122 in an associated manner. The compression unit 110 then performs encoding using the dynamic code. For example, in the example of FIG. 8, the compression unit 110 registers the numerical value data "01F4h" of the numerical value notation character string "500" included in the CSV data 10a and the dynamic code "C200h" in the dynamic dictionary 122 in an associated manner. In FIG. 8, only the numerical value data is described in the dynamic dictionary 122, and the description of the dynamic code is omitted.

The compression unit 110 then outputs the numerical value notation character string "500" to the compressed CSV data 11a in the corresponding dynamic code "C200h". The compression unit 110 also registers the numerical value data "012Ch" of the numerical value notation character string "300" included in the CSV data 10a and the dynamic code "C201h" in the dynamic dictionary 122 in an associated manner. The compression unit 110 then outputs the numerical value notation character string "300" to the compressed CSV data 11a in the corresponding dynamic code "C201h".

As illustrated in the example of FIG. 8, the compression unit 110 can also register a word in the dynamic dictionary 122 in addition to the numerical value notation character string. For example, for a word "chocolate" included in the CSV data 10a, the compression unit 110 registers a word code "c (chocolate)" and the dynamic code "C100h" in the dynamic dictionary 122 in an associated manner. The compression unit 110 then outputs the word "chocolate" to the compressed CSV data 11a in the corresponding dynamic code "C100h". In FIG. 8, the notation of "c (word)" indicates the word code corresponding to the word in parentheses. For example, "c (chocolate)" indicates a word code for "chocolate".

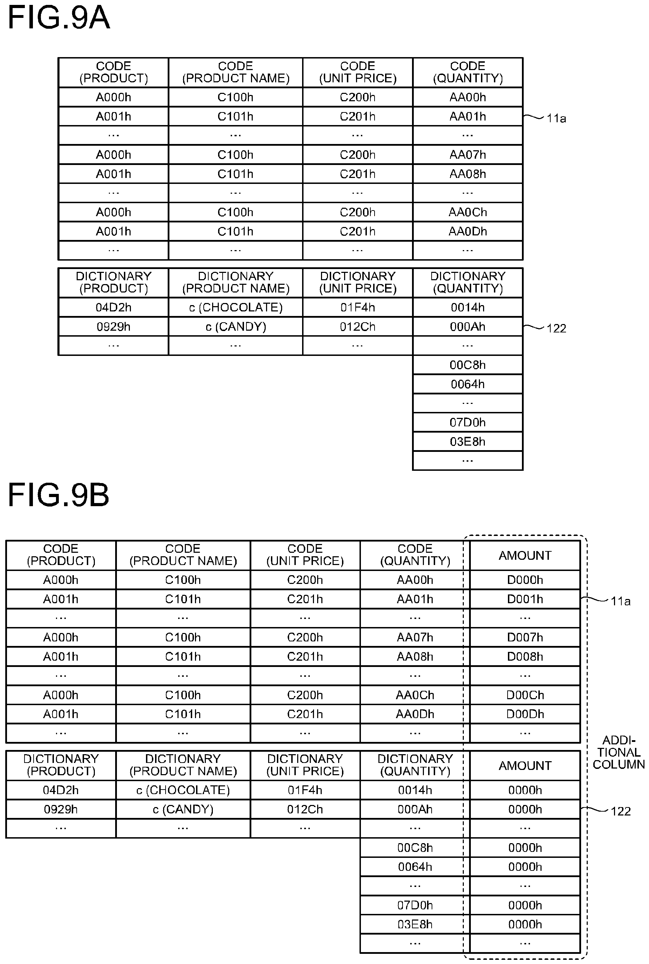

Subsequently, a procedure of calculation using the compressed CSV data 11a will be described. FIG. 9A is a diagram 1 for explaining arithmetic processing of a numerical value in the second embodiment. A state before the arithmetic processing is performed, in other words, the compressed CSV data 11a and the dynamic dictionary 122 in the compressed file 11 illustrated in FIG. 8 is depicted in FIG. 9A. Hereinafter, an example of calculating the sales amount (in other words, unit price × quantity) of each product will be described.

FIG. 9B is a diagram 2 for explaining arithmetic processing of a numerical value in the second embodiment. As illustrated in FIG. 9B, the compression unit 110 first adds a column in which the calculated sales amount is to be input in the compressed CSV data 11a and the dynamic dictionary 122. Next, the compression unit 110 generates dynamic codes corresponding to the added column, and registers the generated dynamic codes in the dynamic dictionary 122. More specifically, the compression unit 110 assigns dynamic codes "D000h", "D001h" to the added column in the compressed CSV data 11a. The compression unit 110 also registers an initial value "0000h" (in other words, a value obtained by binarizing zero) in the added column in the dynamic dictionary 122 as numerical value data.

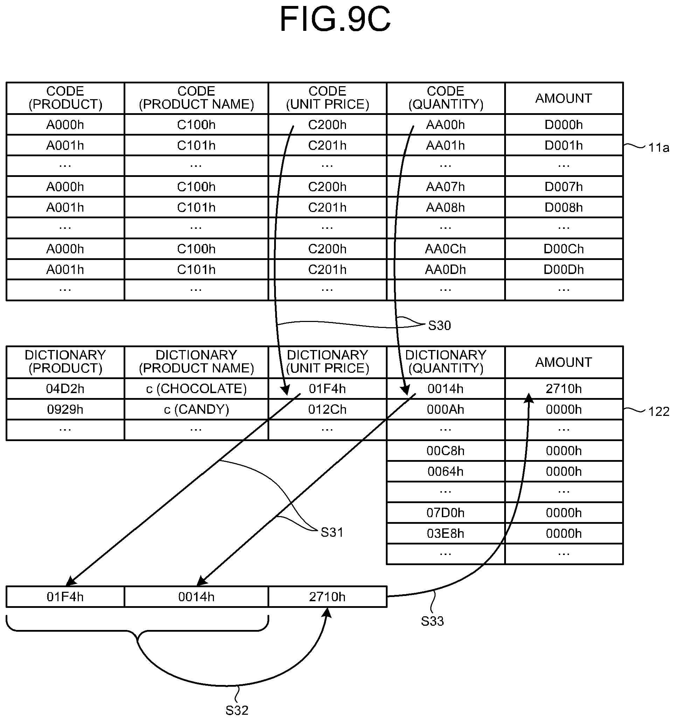

FIG. 9C is a diagram 3 for explaining arithmetic processing of a numerical value in the second embodiment. As illustrated in FIG. 9C, when calculation (multiplication in the example) is performed using the encoded dynamic code, the information processing device 100 extracts the numerical value data corresponding to the dynamic code to be calculated in the compressed CSV data 11a, from the dynamic dictionary 122 (step S30). As illustrated in FIG. 9C, for example, in the compressed CSV data 11a, the information processing device 100 extracts the corresponding numerical value data "01F4h" from the dynamic code "C200h" that is the encoded unit price of the product, and extracts the corresponding numerical value data "0014h" from the dynamic code "AA00h" that is the encoded quantity of the product.

Subsequently, the information processing device 100 stores the extracted numerical value data that it to be calculated in the buffer (step S31). The information processing device 100 then performs calculations using the numerical value data, and stores the calculation result in the buffer (step S32). More specifically, the information processing device 100 multiplies the numerical value data "01F4h" that is obtained by binarizing the numerical value notation character string "500" by the numerical value data "0014h" that is obtained by binarizing the numerical value notation character string "200", and stores the numerical value data "2710h" that is obtained by binarizing the numerical value notation character string "10000", which is the calculation result, in the buffer.

The information processing device 100 then outputs the calculation result to the corresponding added column in the dynamic dictionary 122 (step S33). Consequently, the dynamic code "D000h" in the added column corresponding to the total amount in the compressed CSV data 11a and the numerical value data "2710h", which is the multiplication result, are associated with each other.

In this manner, by using the dynamic dictionary 122 in which the numerical value data and the dynamic code are associated with each other, it is possible to perform calculation with the compressed CSV data 11a encoded. Thus, because there is no need to decode the encoded numerical value notation character string, it is possible to reduce the decoding load during the calculation of the encoded numerical value.

In the second embodiment, calculation is performed by multiplication. However, the calculation is not limited to multiplication, and the other four arithmetic operations such as addition, subtraction, and division may also be performed. It is also possible to perform calculation without using the four arithmetic operations.

### Advantageous Effects

The information processing device 100 performs calculations using the numerical value data corresponding to the code (dynamic code) registered in the dictionary. Consequently, it is possible to reduce the decoding load when the encoded numerical value is to be calculated.

### Other Aspects of First and Second Embodiments

Hereinafter, a part of modification of the above-described embodiments will be explained. Not only the following modifications, the embodiments can be suitably modified without departing from the scope of the present invention.

The target of the encoding process may also be a monitor message and the like output from the system, in addition to the data in the file. For example, a process of compressing monitor messages that are sequentially stored in the buffer by the above-described encoding process, and storing the monitor message as a log file is performed. Moreover, for example, compression may be performed in page units in the database, or in units of collected pages.

The processing procedure, the control procedure, the specific names, and information including various types of data and parameters illustrated in the first embodiment can be optionally changed unless otherwise specified.

### Hardware Configuration of Information Processing Device

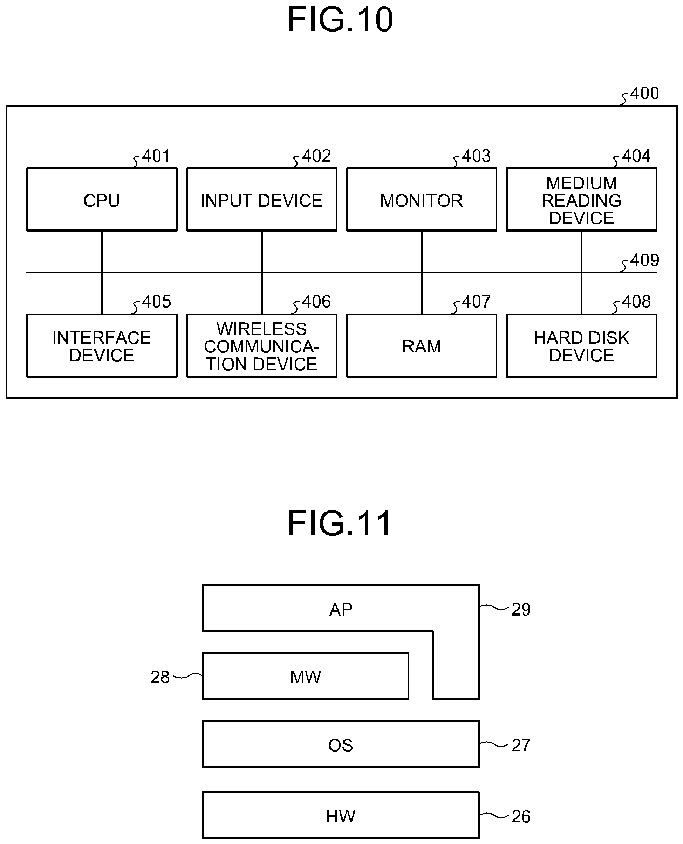

FIG. 10 is a diagram illustrating a hardware configuration of the information processing device 100 in the first and second embodiments. As illustrated in the example of FIG. 10, a computer 400 includes a CPU 401 that executes various arithmetic operations, an input device 402 that receives data input from a user, and a monitor 403. The computer 400 also includes a medium reading device 404 that reads out a computer program and the like from a storage medium, an interface device 405 for connecting with the other device, and a wireless communication device 406 for wirelessly connecting with the other device. The computer 400 also includes a RAM 407 that temporarily stores therein various types of information, and a hard disk device 408. The devices 401 to 408 are connected to a bus 409.

For example, an information processing program having the same functions as those of the function units of the file reading unit 111, the dynamic code assigning unit 112, and the file writing unit 113 illustrated in FIG. 3 is stored in the hard disk device 408. Moreover, various types of data for implementing the information processing program are stored in the hard disk device 408.

The CPU 401 performs various processes by reading out computer programs stored in the hard disk device 408, developing the computer programs in the RAM 407, and executing the computer programs. For example, these computer programs cause the computer 400 to function as the file reading unit 111, the dynamic code assigning unit 112, and the file writing unit 113 illustrated in FIG. 3.

The above-described information processing program need not be stored in the hard disk device 408. For example, a computer program stored in a storage medium readable by the computer 400 may be read out and executed by the computer 400. For example, the storage medium readable by the computer 400 corresponds to a portable recording medium such as a compact disc-read only memory (CD-ROM), a digital versatile disc (DVD), and a universal serial bus (USB) memory; a semiconductor memory such as a flash memory; a hard disk drive, and the like. The computer program may also be stored in a device connected to a public line, the Internet, a local area network (LAN), and the like, and the computer 400 may read the computer program therefrom and execute the computer program.

FIG. 11 is a diagram illustrating a structural example of a computer program operated in the computer 400. In the computer 400, an operating system (OS) 27 that controls a hardware group 26 (401 to 409) illustrated in FIG. 10 is operated. The hardware group 26 executes the process according to an application program 29 and the middleware 28, when the CPU 401 is operated by the procedure according to the OS 27, and the hardware group 26 is controlled and managed. In the computer 400, the middleware 28 or the application program 29 is read in the RAM 407, and executed by the CPU 401.

When the compression function is called by the CPU 401, the function of the compression unit 110 is implemented by performing a process on the basis of at least a part of the middleware 28 or the application program 29 (by controlling the hardware group 26 on the basis of the OS 27). The compression function may be included in the application program 29, or may be a part of the middleware 28 that is called and executed according to the application program 29.

The compressed file 11 obtained by the compression function of the application program 29 (or middleware 28) may be partially expanded. When the middle part of the compressed file 11 is to be expanded, the expansion process of the compressed data up to the portion to be expanded is suppressed. Thus, the load of the CPU 401 will be suppressed. Moreover, because the compressed data to be expanded is partially developed on the RAM 407, the work area will be reduced.

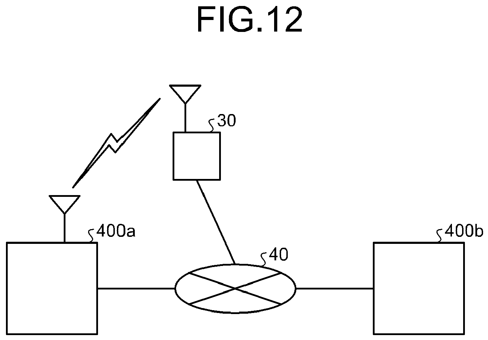

FIG. 12 is a diagram illustrating a structural example of devices in a system in the embodiments. The system in FIG. 12 includes a computer 400a, a computer 400b, a base station 30, and a network 40. The computer 400a is either wirelessly or wiredly connected to the network 40 that is connected to the computer 400b.

According to the embodiments, it is possible to accelerate the calculation speed of an encoded numerical value.

## Claims

1. An encoding program that causes a computer to execute a process comprising:
reading (111) data to be encoded from target text data;
encoding (112) a numerical value notation character string representing a numerical value included in the data to be encoded; and
registering (112) numerical value data corresponding to the numerical value notation character string and a code in a dictionary in an associated manner based on the encoding.

2. The encoding program according to claim 1, wherein the numerical value data is data obtained by binarizing the numerical value represented by the numerical value notation character string.

3. The encoding program according to claim 1 or 2, wherein the process further comprises calculating (113) using the numerical value data corresponding to the code registered in the dictionary.

4. An encoding device comprising:
a reading unit (111) that reads data to be encoded from target text data;
an encoding execution unit (112) that encodes a numerical value notation character string representing a numerical value included in the data to be encoded; and
a registration unit (112) that registers numerical value data corresponding to the numerical value notation character string and a code in a dictionary in an associated manner based on the encoding.

5. An encoding method comprising:
reading (111) data to be encoded from target text data;
encoding (112) a numerical value notation character string representing a numerical value included in the data to be encoded; and
registering (112) numerical value data corresponding to the numerical value notation character string and a code in a dictionary in an associated manner based on the encoding.
